# EUROPEAN PATENT SPECIFICATION

(11) **EP 4 632 815 B1**
(45) Date of publication and mention of the grant of the patent: **07.10.2026**
(21) Application number: 25164989.3
(22) Date of filing: 20.03.2025
(51) Int. Cl.: H10W 90/10, G01K 1/14, H10W 44/00, H10W 40/00, H10W 40/25, H10W 70/60, H10W 90/00

(54) **SEMICONDUCTOR MODULE**
HALBLEITERMODUL
MODULE SEMI-CONDUCTEUR

(30) Priority: 28.03.2024 JP 2024052722
(43) Date of publication of application: 15.10.2025
(73) Proprietor: Shindengen Electric Manufacturing Co., Ltd., Tokyo 100-0004 (JP)
(72) Inventor: YUGUCHI, Junya, Saitama, 3518503 (JP); MORINAGA, Yuji, Saitama, 3518503 (JP)
(74) Representative: Liesegang, Eva

(56) References cited:
- US-A1- 2021 167 673
- US-A1- 2024 019 315

## Description

### [Technical Field]

The present invention relates to a semiconductor module.

### [Background Art]

Conventionally, in a technical field of a semiconductor module, a semiconductor module that includes a temperature detection element (for example, a thermistor) has been known (see non-patent literature 1).

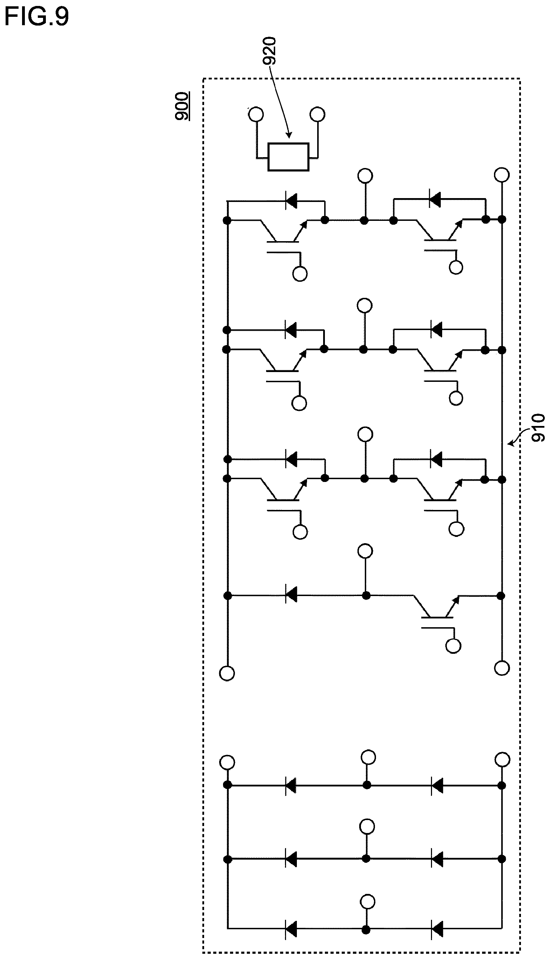

As illustrated in Fig. 9, the conventional semiconductor module 900 is a semiconductor module that includes an inverter circuit 910. The semiconductor module 900 further includes a thermistor 920 on a peripheral edge thereof. According to the conventional semiconductor module 900, it is possible to detect a temperature in the semiconductor module 900 by the thermistor 920.

### [Prior Art Literature]

Document US2021/0167673 A1 shows:
a semiconductor module comprising:
first to fourth semiconductor elements; a plurality of wiring patterns; a first power source terminal;
a second power source terminal; a first intermediate point terminal; and a second intermediate point terminal, wherein a full bridge circuit is formed where a first switching path and a second switching path are formed exclusively by a switching operation, the first switching path including a first current path that extends from the first power source terminal to the first intermediate point terminal and a second current path that extends from the second intermediate point terminal to the second power source terminal, the second switching circuit including a third current path that extends from the first power source terminal to the second intermediate point terminal and a fourth current path that extends from the first intermediate point terminal to the second power source terminal, wherein the semiconductor module further comprises:a temperature detection element that includes a first temperature detection electrode and a second temperature detection electrode, and is disposed in a region surrounded by the first switching path and the second switching path;a first temperature detection wiring pattern that is connected with the first temperature detection electrode;a first temperature detection terminal that is a terminal to be connected with a temperature detection circuit, and is connected with the first temperature detection wiring pattern;a second temperature detection wiring pattern that is connected with the second temperature detection electrode;a second temperature detection terminal that is a terminal to be connected with a ground or a control system power source, and is connected with the second temperature detection wiring pattern.

Furthermore, document US2024/0019315 A1 discloses the temperature measurement in a noise voltage inducing environment, such as a power module, due to the magnetic coupling between the power loop and the current loop relating to the temperature detection element. A filter, which can be a notch filter, is implemented in the power module for improving the temperature measurement.

### [Non-patent literature]

[Non-patent Literature 1] IGBT module T series CM35MXUA-24T datasheet, [online], Mitsubishi Electric Corporation [retrieved on 2024, March 1st], internet, <URL:https://www.mitsubishielectric.co.jp/semiconductors/powerdevices/datasheets/igbt/t_serie s/cm35mxua-24t_e.pdf>

### [Summary of Invention]

### [Technical Probleml

However, in the technical field of a semiconductor module, there has been a demand for the more accurate temperature detection of the inside of a semiconductor module. For example, a semiconductor module that uses a wideband gap semiconductor element (for example, an SiC semiconductor element) is used with large electric power compared to a semiconductor module that uses a silicon semiconductor element. Accordingly, such a semiconductor module generates a large heat and hence, there is a tendency that an operation temperature of the semiconductor module becomes high. Accordingly, in a semiconductor module that uses a wideband gap semiconductor module, it is necessary to more accurately perform the temperature detection of the semiconductor module. A temperature control of the semiconductor module is a universally important technique in the technical field of the semiconductor module. Accordingly, a semiconductor module that uses a silicon semiconductor element can receive a benefit acquired by performing the temperature detection more accurately.

The present invention has been made in view of the above-mentioned circumstances, and it is an object of the present invention to provide a semiconductor module capable of more accurately performing the temperature detection compared to a prior art.

### [Solution to Problem]

[1] A semiconductor module according to one aspect of the present invention is a semiconductor module that includes: first to fourth semiconductor elements; a plurality of wiring patterns; a first power source terminal; a second power source terminal; a first intermediate point terminal; and a second intermediate point terminal. A full bridge circuit is formed where a first switching path and a second switching path are formed exclusively by a switching operation, the first switching path including a first current path that extends from the first power source terminal to the first intermediate point terminal and a second current path that extends from the second intermediate point to the second power source terminal, the second switching circuit including a third current path that extends the first intermediate point terminal to the second intermediate point terminal and a fourth current path that extends from the first intermediate point terminal to the second power source terminal. The semiconductor module further includes: a temperature detection element that includes a first temperature detection electrode and a second temperature detection electrode, and is disposed in a region surrounded by the first switching path and the second switching path; a first temperature detection wiring pattern that is connected with the first temperature detection electrode; a first temperature detection terminal that is a terminal to be connected with a temperature detection circuit, and is connected with the first temperature detection wiring pattern; a second temperature detection wiring pattern that is connected with the second temperature detection electrode; a second temperature detection terminal to be connected with a ground or a control system power source, and is connected with the second temperature detection wiring pattern; a first capacitor that is disposed between a first temperature detection path that extends from the first temperature detection electrode to the first temperature detection terminal and a common portion between the first current path and the fourth current path; and a second capacitor that is disposed between the first temperature detection path and a common portion between the second current path and the third current path.
[2] In the semiconductor according to one aspect of the present invention, it is preferred that the semiconductor module further includes: a sealing material that seals the first to fourth semiconductor elements, the plurality of wiring patterns and the temperature detection elements, and seals respective inner lead portions of the first power source terminal, the second power source terminal, the first intermediate point terminal, the second intermediate point terminal, the first temperature detection terminal and the second temperature detection terminal, and the first capacitor and the second capacitor are disposed in the sealing material.
[3] In the semiconductor according to one aspect of the present invention, it is preferred that the semiconductor module further includes: a sealing material that seals the first to fourth semiconductor elements and the plurality of wiring patterns, and seals respective inner lead portions of the first power source terminal, the second power source terminal, the first intermediate point terminal, and the second intermediate point terminal, and the first capacitor and the second capacitor are disposed outside the sealing material.
[4] In the semiconductor according to one aspect of the present invention, it is preferred that the second temperature detection wiring pattern is disposed between the first temperature detection wiring pattern and a wiring pattern that constitutes a common portion between the first current path and the fourth current path or between the first temperature detection wiring pattern and a wiring pattern that constitutes a common portion between the second current path and the third current path, and the semiconductor module further comprises a capacitive coupling reducing wiring pattern that is disposed on a side where the second temperature detection wiring pattern is not disposed, out of between the first temperature detection wiring pattern and a common portion between the first current path and the fourth current path and between the first temperature detection wiring pattern and a common portion between the second current path and the third current path.

### [Advantageous Effects of the Present Invention]

In the semiconductor module according to the present invention, the temperature detection element is disposed in the region surrounded by the first switching path and the second switching path in the full bridge circuit and is disposed in the vicinity of a heat generation source. With such a configuration, the semiconductor module according to the present invention becomes a semiconductor module that can accurately perform the temperature detection compared to the prior art.

The semiconductor module according to the present invention includes: "a first capacitor that is disposed between the first temperature detection path that extends from the first temperature detection electrode to the first temperature detection terminal and a common portion between a first current path and a fourth current path"; "a second capacitor that is disposed between the first temperature detection path and a common portion between a second current path and a third current path". With such a configuration, according to the semiconductor module of the present invention, a capacitance between the first temperature detection path and the first current path on the first switching path and a capacitance between the first temperature detection path and a second current path on the first switching path are balanced and hence, noises generated at the time of switching can be reduced. Further, according to the semiconductor module of the present invention, a capacitance between the first temperature detection path and a third current path on the second switching path and a capacitance between the first temperature detection path and a fourth current path on the second switching path are balanced and hence noises generated at the time of switching can be reduced. As a result, an output voltage of the temperature detection element becomes stable and hence, semiconductor module according to the present invention becomes a semiconductor module that can perform the temperature detection in a more stable manner.

### [Brief Description of Drawings]

Fig. 1 is a plan view of the internal configuration of a semiconductor module 1 according to an embodiment. In Fig. 1, to illustrate the internal configuration of the semiconductor module 1, only an outer edge is illustrated with respect to a sealing material M, and portions of the sealing material M that overlap with other constitutional elements are not illustrated. The same goes for plan views of other internal configurations, and an explanatory view of current paths and a main part enlarged view described later.
Fig. 2 is a main part enlarged view illustrating a main part in Fig. 1.
Fig. 3 is an equivalent circuit diagram of the semiconductor module 1 according to the embodiment.

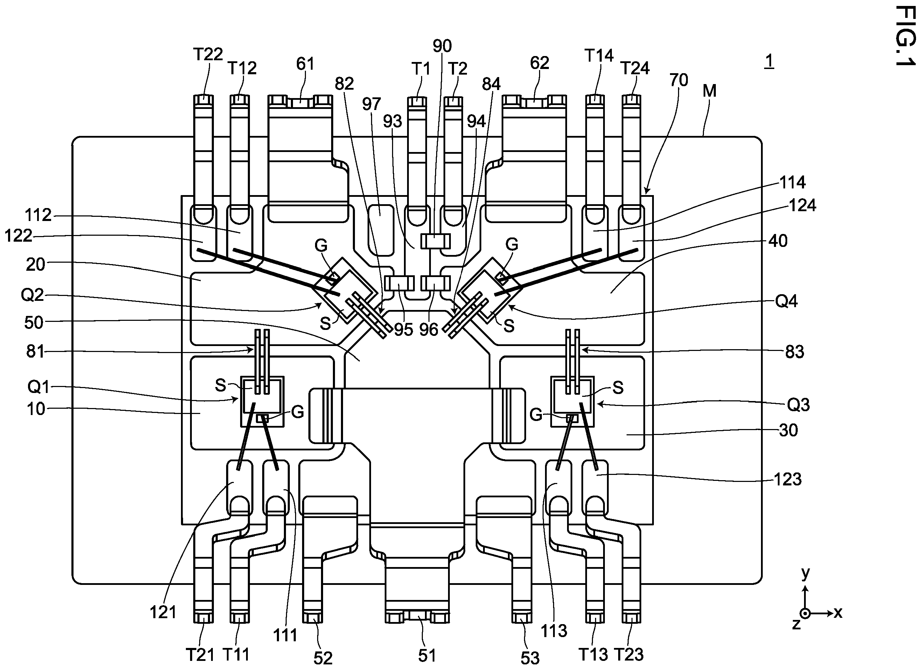

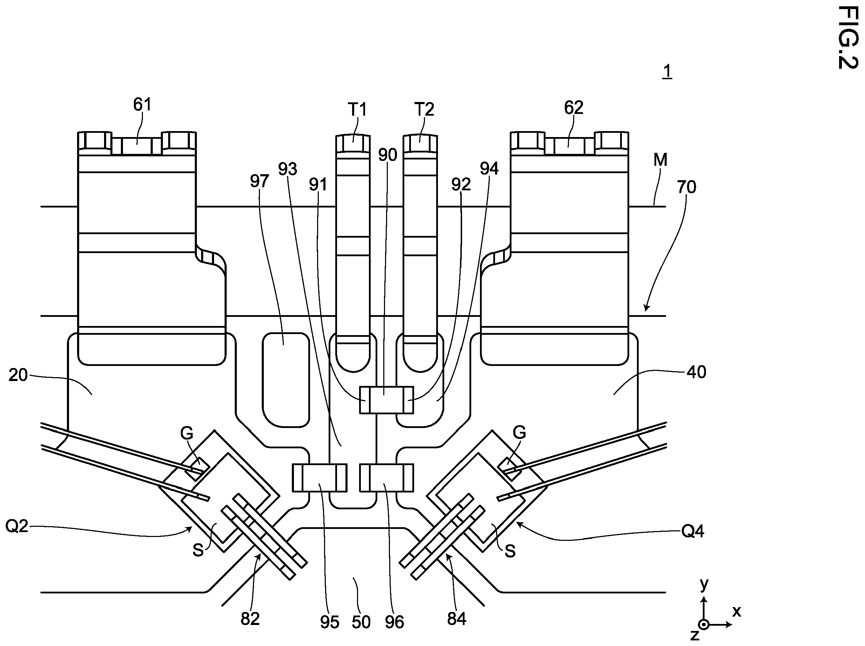

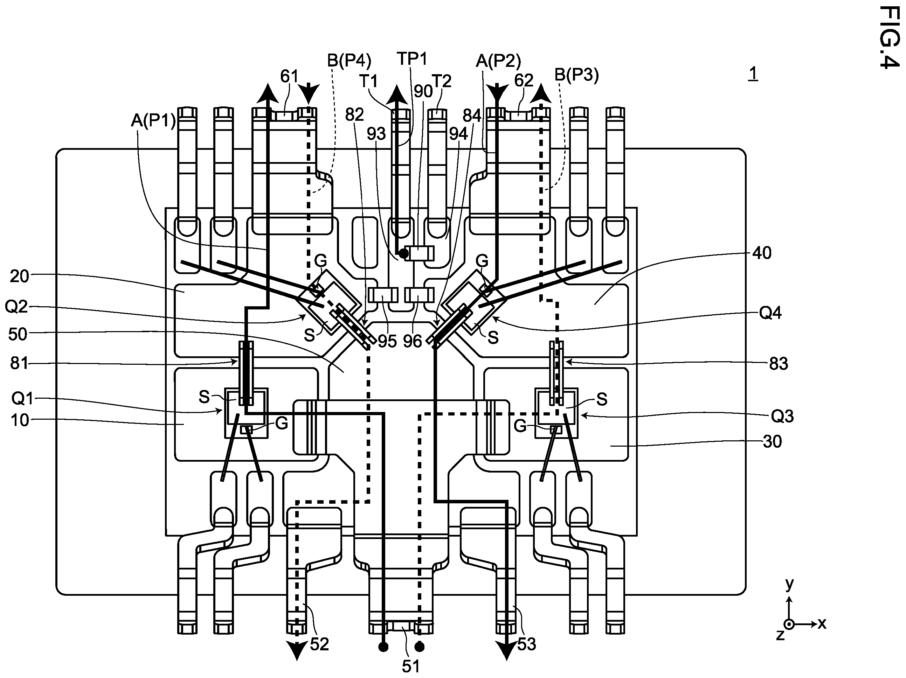

Fig. 4 is an explanatory view of current paths of the semiconductor module 1 according to the embodiment. Fig. 4 is a view obtained by adding the current path to the semiconductor module 1 illustrated in Fig. 1, and the configuration of the semiconductor module illustrated in Fig. 4 is substantially equal to the corresponding configuration illustrated in Fig. 1. However, in Fig. 4, with respect to symbols that indicate respective constitutional elements illustrated in Fig. 2, some symbols are omitted, and mainly, the symbols of constitutional elements necessary for describing the current path are described.
Fig. 5 is a plan view of the internal configuration of a semiconductor module 1A according to a comparison example.
Fig. 6 is an explanatory view of current paths of the semiconductor module 1A according to the comparison example.

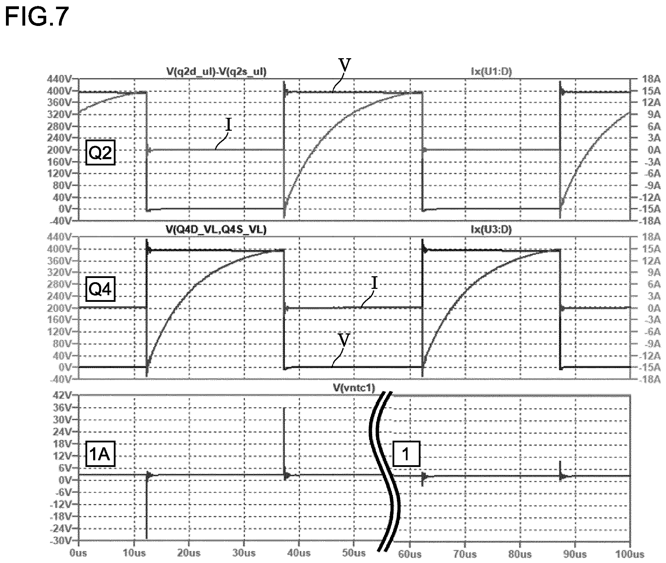

Fig. 7 is a graph illustrating a noise characteristic of the semiconductor module 1 according to the embodiment and a noise characteristic of the semiconductor module 1A according to the comparison example. In Fig. 7, a graph at an upper stage, a graph at an intermediate stage, and a graph at a lower stage are illustrated in parallel in a vertical direction such that lateral axes (times) of the respective graphs are aligned with each other. A graph at the upper stage (a graph indicated by "Q2") is a graph indicating a change in voltage V and a change in current I of a second semiconductor element Q2 when a full bridge circuit is operated. A graph at the intermediate stage (a graph indicated by "Q4") is a graph indicating a change in voltage V and a change in current I of a fourth semiconductor element Q4 when a full bridge circuit 100 is operated. A graph at the lower stage (a graph indicated by "1A" and "1") is a graph indicating a change in a voltage of a first temperature detection path TP1 when the full bridge circuit is operated. The graph at the lower stage is divided into two graphs. The graph on a side where the indication "1A" exists is a graph indicating a change in voltage in the semiconductor module 1A according to the comparison example. The graph on a side where the indication "1" exists is a graph indicating a change in voltage in the semiconductor module 1 according to the embodiment. Numerical values of voltages are described at the left ends of the respective graphs, and numerical values of the currents are indicated at the right ends of the graph at the upper stage and the graph at the lower stage.
Fig. 8 is an equivalent circuit diagram of a semiconductor module 2 according to a modification.
Fig. 9 is an equivalent circuit diagram of a conventional semiconductor module 900.

### [Description of Embodiments]

Hereinafter, a semiconductor module according to the present invention is described based on an embodiment illustrated in the drawings. The embodiment described hereinafter is not intended to limit the present invention called for in claims. Further, it is not always the case that all of various elements described in the embodiment and combinations of these elements are indispensable as a means to solve the problems of the present invention.

### [Embodiment]

### 1. Configuration of semiconductor module 1

As illustrated in Fig. 1 and Fig. 2, the semiconductor module 1 according to the embodiment 1 includes: first to fourth semiconductor elements Q1 to Q4; a plurality of wiring patterns; a first power source terminal 51; second power source terminals 52, 53; a first intermediate point terminal 61; and a second intermediate point terminal 62. The plurality of wiring patterns include first to fifth wiring patterns 10 to 50 through which a main current (a large current) flows.

The semiconductor module 1 further includes: a board 70; a temperature detection element 90; other wiring patterns; other terminals; first and second capacitor 95, 96; and a sealing material M. The other wiring patterns include: first and second temperature detection wiring pattern 93, 94; a capacitive coupling reducing wiring pattern 97; first to fourth control wiring patterns 111 to 114; and first to fourth detection wiring patterns 121 to 124. Further, the other terminals include: first and second temperature detection terminals T1, T2; first to fourth control terminals T11 to T14; and first to fourth detection terminals T21 to T24.

Hereinafter, the above-mentioned respective constitutional elements are described.

In the semiconductor module 1, the first to fourth semiconductor elements Q1 to Q4 are metal oxide semiconductor field effect transistors (MOSFETs). The first to fourth semiconductor elements Q1 to Q4 each have a source electrode S, a drain electrode D, and a gate electrode G.

In a case where the first to fourth semiconductor elements Q1 to Q4 are vertical transistor elements, the drain electrode D exists on a surface of each of the first to fourth semiconductor elements Q1 to Q4 on a first to fourth wiring pattern 10 to 40 side. In the semiconductor module 1, the case is illustrated where the first to fourth semiconductor elements Q1 to Q4 are vertical transistor elements. Accordingly, when the semiconductor module 1 is viewed in a plan view as in the case of Fig. 1, the drain electrodes D are not viewed. Accordingly, a symbol "D" that indicates the drain electrodes in the respective drawings is not illustrated in the respective drawings. Further, the gate electrode G exists on a surface of each of the first to fourth semiconductor elements Q1 to Q4 on a source electrode S side.

The first to fourth semiconductor elements Q1 to Q4 are suitably changeable within a scope where the gist of the present invention is not changed. The first to fourth semiconductor elements Q1 to Q4 are not limited to MOSFETs, and may be other semiconductor elements such as insulated gate bipolar transistors (IGBTs) or the like.

Further, the first to fourth semiconductor elements Q1 to Q4 may be, for example, lateral transistor elements (for example, GaN-HEMT formed using a GaN-on-Si material, compound-semiconductor transistor elements or the like made of a Ga₂O₃-on-Si material). Further, the first to fourth semiconductor elements Q1 to Q4 are not limited to transistor elements, and transistor elements may have modified configurations where the transistor element is suitably replaced with a diode element corresponding to circuit application. By adopting such modified configurations, the present invention becomes suitably applicable to a totem-pole-type bridgeless PFC circuit and the like.

The source electrode S of the first semiconductor element Q1 is connected with the second wiring pattern 20 via a first connection member 81. As the first connection member 81 and second to fourth connection members 82 to 84 described later, for example, a connection member made of an aluminum wire can be used. Further, the drain electrode D of the first semiconductor element Q1 is connected with the first wiring pattern 10.

The source electrode S of the second semiconductor element Q2 is connected with the fifth wiring pattern 50 via the second connection member 82. The drain electrode D of the second semiconductor element Q2 is connected with the second wiring pattern 20.

The source electrode S of the third semiconductor element Q3 is connected with the fourth wiring pattern 40 via the third connection member 83. Further, the drain electrode D of the third semiconductor element Q3 is connected with the third wiring pattern 30.

The source electrode S of the fourth semiconductor element Q4 is connected with the fifth wiring pattern 50 via the fourth connection member 84. Further, the drain electrode D of the fourth semiconductor element Q4 is connected with the fourth wiring pattern 40.

The first to fifth wiring patterns 10 to 50 in the semiconductor module 1 are each made of an electrically conductive material disposed or formed on a base of the board 70. The other wiring patterns described later are substantially equal to the first to fifth wiring patterns 10 to 50 with respect to a point that the wiring patterns are made of an electrically conductive material disposed or formed on the base of the board 70.

With respect to the semiconductor module 1, as the board 70, a direct copper bonding (DCB) board formed by directly bonding metal (copper) to a base made of ceramic (alumina, aluminum nitride, silicon nitride or the like) can be suitably used.

The board in the semiconductor module according to the present invention is not limited to the DCB board. As the board, other ceramic boards such as an active metal brazing (AMB) board, a metal base board having a copper base or an aluminum base and the like can be also used. Further, as a material for forming the plurality of wiring patterns, metal other than copper (for example, aluminum) can be also used.

The first semiconductor element Q1 is mounted on the first wiring pattern 10, and the first power source terminal 51 is connected with the first wiring pattern 10. The second semiconductor element Q2 is mounted on the second wiring pattern 20, and a first intermediate point terminal 61 is connected with the second wiring pattern 20. The third semiconductor element Q3 is mounted on the third wiring pattern 30, and the first power source terminal 51 is connected with the third wiring pattern 30. The fourth semiconductor element Q4 is mounted on the fourth wiring pattern 40, and a second intermediate point terminal 62 is connected with the fourth wiring pattern 40. The second power source terminals 52, 53 are connected with the fifth wiring pattern 50.

The first power source terminal 51 and the second power source terminals 52, 53 are terminals for supplying electricity to a full bridge circuit. In the semiconductor module 1, the first power source terminal 51 assumes a current input side (high voltage side), and the second power source terminal 52 assumes a current output side (ground side).

The first power source terminal 51 is a member having an approximately T shape where an inner lead portion (a portion existing in a sealing material M) is branched. The first power source terminal 51 strides over the fifth wiring pattern 50 in a non-contact manner, and is connected with the first wiring pattern 10 and the third wiring pattern 30.

The second power source terminals 52, 53 are respectively connected with the fifth wiring pattern 50. The second power source terminals 52, 53 are disposed so as to sandwich the first power source terminal 51 therebetween.

The first intermediate point terminal 61 and the second intermediate point terminal 62 are terminals with which a load not illustrated in the drawing is connected. The first intermediate point terminal 61 is connected with the second wiring pattern 20, and the second intermediate point terminal 62 is connected with the fourth wiring pattern 40.

The temperature detection element 90 includes a first temperature detection electrode 91 and a second temperature detection electrode 92, and is disposed in a region surrounded by a first switching path A and a second switching path B. The first and second switching paths A, B are described in paragraphs relating to the full bridge circuit 100 and the current paths described later. "Temperature detection element" in the present invention means an element that changes an electric characteristic (for example, resistance) generated by a change in temperature. As the temperature detection element 90, a thermistor can be preferably used.

The first temperature detection pattern 93 is connected with the first temperature detection electrode 91. The second temperature detection wiring pattern 94 is connected with the second temperature detection electrode 92. In the semiconductor module 1, the second temperature detection wiring pattern 94 is disposed between a first temperature detection wiring pattern 93 and a wiring pattern (the fourth wiring pattern 40) that constitutes a common portion between a second current path P2 (described later) and a third current path P3 (described later).

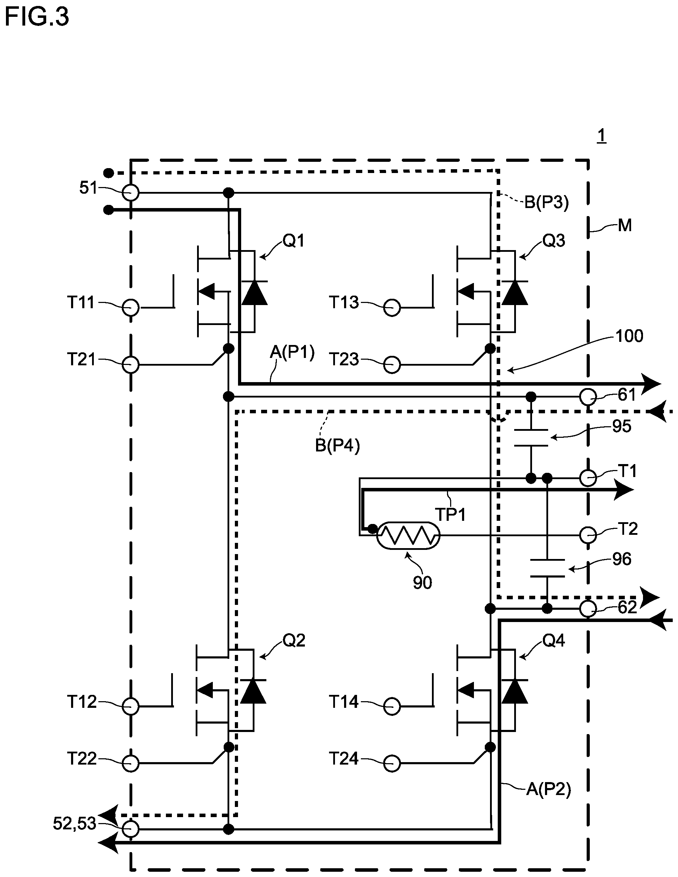

The first capacitor 95 is disposed between a first temperature detection path TP1 that extends from the first temperature detection electrode 91 to the first temperature detection terminal T1 (see Fig. 3 and Fig. 4), and a common portion between a first current path P1 (described later) and a fourth current path P4 (described later). It is safe to say that the first temperature detection path TP1 in the semiconductor module 1 is constituted of the first temperature detection electrode 91, the first temperature detection wiring pattern 93 and the first temperature detection terminal T1. The first capacitor 95 is disposed between the first temperature detection wiring pattern 93 and the second wiring pattern 20.

The second capacitor 96 is disposed between the first temperature detection path TP1 and the common portion between the second current path P2 (described later) and the third current path P3 (described later). The second capacitor 96 is disposed between the first temperature detection wiring pattern 93 and the fourth wiring pattern 40.

The first capacitor 95 and the second capacitor 96 are disposed in the sealing material M.

The capacitive coupling reducing wiring pattern 97 is, out of between the first temperature detection wiring pattern 93 and the wiring pattern (the second wiring pattern 20) that constitutes the common portion between a first current path P1 (described later) and a fourth current path P4 (described later), and between the first temperature detection wiring pattern 93 and the wiring pattern (the fourth wiring pattern 40) that constitutes a common portion between the second current path P2 (described later) and the third current path P3 (described later), disposed on a side where the second temperature detection wiring pattern 94 is not disposed. The capacitive coupling reducing wiring pattern 97 in the semiconductor module 1 is disposed between the first temperature detection wiring pattern 93 and the second wiring pattern 20.

The first temperature detection terminal T1 is a terminal that is to be connected with a temperature detection circuit (not illustrated in the drawing), and is connected with the first temperature detection wiring pattern 93. In this specification, "temperature detection circuit" means a circuit that is formed including a temperature detection element, and can detect a temperature in response to a change in an electrical characteristic of the temperature detection element.

The second temperature detection terminal T2 is a terminal that is to be connected with a ground or a control system power source (not illustrated in the drawing), and is connected with the second temperature detection wiring pattern 94. In this specification, "control system power source means a power source device that supplies electricity for operating the temperature detection circuit. Such a control system power source is a power source device different from a power source (main power source) that supplies electricity to the first and second power source terminals. The control system power in this specification may also supply power to circuits and devices other than the temperature detection circuit.

The first to fourth control wiring patterns 111 to 114 are connected with the respective gate electrodes G of the first to fourth semiconductor elements Q1 to Q4 via connection members such as aluminum wires respectively. Further, the first to fourth control wiring patterns 111 to 114 are connected with the first to fourth control terminals T11 to T14 respectively corresponding to the first to fourth control wiring patterns 111 to 114. Accordingly, the gate electrodes G of the first to fourth semiconductor elements Q1 to Q4 are respectively connected with the first to fourth control terminals T11 to T14.

The first to fourth detection wiring patterns 121 to 124 are connected with the respective source electrodes S of the first to fourth semiconductor elements Q1 to Q4 via connection members such as aluminum wires respectively. Further, the first to fourth detection wiring patterns 121 to 124 are connected with the first to fourth detection terminals T21 to T24 respectively corresponding to the first to fourth detection wiring patterns 121 to 124. Accordingly, the source electrodes S of the first to fourth semiconductor elements Q1 to Q4 are connected with the first to fourth detection terminals T21 to T24.

The sealing material M seals the first to fourth semiconductor elements Q1 to Q4, the plurality of wiring patterns and the temperature detection element 90. The sealing material M also seals respective inner lead portions of the first power source terminal 51, the second power source terminals 52, 53, the first intermediate point terminal 61, the second intermediate point terminal 62, the first temperature detection terminal T1 and the second temperature detection terminal T2. The sealing material M is made of a resin, for example.

### 2. Full bridge circuit 100 and current path in semiconductor module 1

At this stage, the full bridge circuit 100 and the current path in the semiconductor module 1 are described. As illustrated in Fig. 3 and Fig. 4, in the semiconductor module 1, the full bridge circuit 100 is constituted where the first switching path A and the second switching path B are exclusively formed by a switching operation. In Fig. 3 and Fig. 4, the first switching path A is indicated by a solid-line arrow, and the second switching path B is indicated by a broken-line arrow.

In the full bridge circuit 100 of the semiconductor module 1, the first semiconductor element Q1 and the third semiconductor element Q3 are disposed at a high side, and the second semiconductor element Q2 and the fourth semiconductor element Q4 are disposed at a low side. In such a full bridge circuit, an operation that both the first semiconductor element Q1 and the fourth semiconductor element Q4 are turned on, and an operation where both the third semiconductor element Q3 and the second semiconductor element Q2 are turned on are alternately repeated.

When both the first semiconductor element Q1 and the fourth semiconductor element Q4 are turned on, both the third semiconductor element Q3 and the second semiconductor element Q2 are turned off, while when both the third semiconductor element Q3 and the second semiconductor element Q2 are turned on, both the first semiconductor element Q1 and the fourth semiconductor element Q4 are turned off. The description relating to the state that the semiconductor element is turned off is omitted in the description hereinafter.

As indicated by a solid-line arrow in Fig. 3 and Fig. 4, the first switching path A includes: a first current path P1 that extends from the first power source terminal 51 to the first intermediate point terminal 61; and a second current path P2 that extends from the second intermediate point terminal 62 to the second power source terminals 52, 53. The first current path P1 is a current path where a current passes through the first power source terminal 51, the first wiring pattern 10, the first semiconductor element Q1, the second wiring pattern 20 and the first intermediate point terminal 61. The second current path P2 is a current path where a current passes through the second intermediate point terminal 62, the fourth wiring pattern 40, the fourth semiconductor element Q4, the fifth wiring pattern 50 and the second power source terminals 52, 53. In Fig. 4, it is illustrated that, in the second current path P2, a current passes through the second power source terminal 53 but does not pass through the second power source terminal 52. However, such illustration is provided for preventing the complication of the drawing. In an actual configuration, in the second current path P2, a current passes through both the second power source terminals 52, 53.

Further, as indicated by a broken-line arrow in Fig. 3 and Fig. 4, the second switching path B includes: a third current path P3 that extends from the first power source terminal 51 to the second intermediate point terminal 62; and a fourth current path P4 that extends from the first intermediate point terminal 61 to the second power source terminals 52, 53. The third current path P3 is a current path that passes through the first power source terminal 51, the third wiring pattern 30, the third semiconductor element Q3, the fourth wiring pattern 40 and the second intermediate point terminal 62. The fourth current path P4 is a current path that passes the first intermediate point terminal 61, the second wiring pattern 20, the second semiconductor element Q2, the fifth wiring pattern 50 and the second power source terminals 52, 53. In Fig. 4, it is illustrated that, in the fourth current path P4, a current passes through the second power source terminal 52, and does not pass through the second power source terminal 53. However, this illustration is provided for preventing the complication of the drawing. In an actual configuration, in the fourth current path P4, a current passes through both the second power source terminals 52, 53.

Accordingly, in the semiconductor module 1, "a common portion between the first current path P1 and the fourth current path P4" with which one end of the first capacitor 95 is to be connected is implemented by the second wiring pattern 20 or the first intermediate point terminal 61 as a specific component. Further, in the semiconductor module 1, "a common portion between the second current path P2 and the third current path P3" with which one end of the second capacitor 96 is connected is implemented by the fourth wiring pattern 40 or the second intermediate point terminal 62 as a specific component.

### 3. Verification by simulation

Hereinafter, the description is made with respect to a result obtained by a simulation performed by inventors of the present invention relating to advantageous effects of the semiconductor module according to the present invention.

Such simulation was carried out with respect to the semiconductor module 1 according to the embodiment and a semiconductor module 1A according to a comparison example.

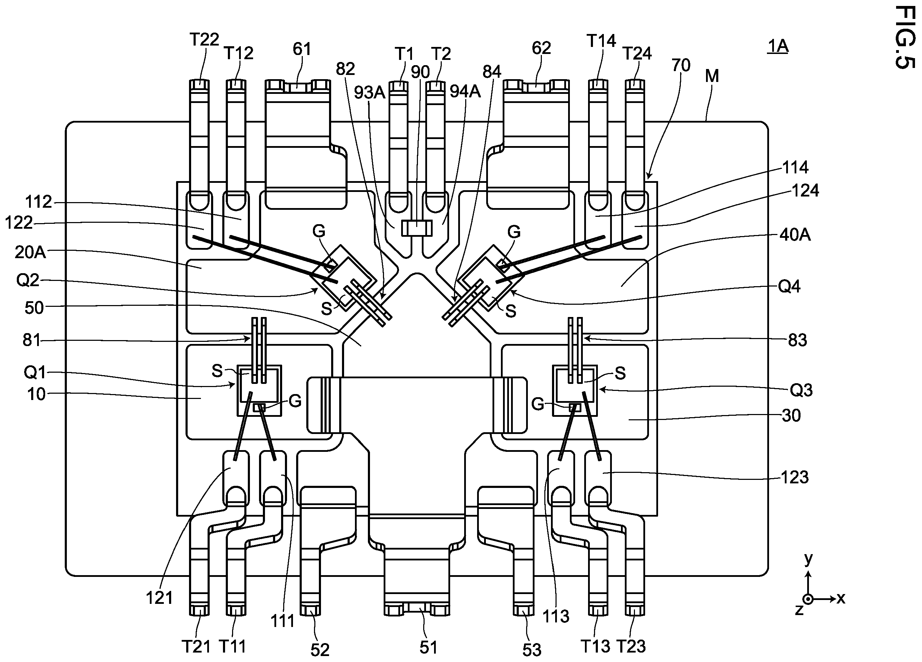

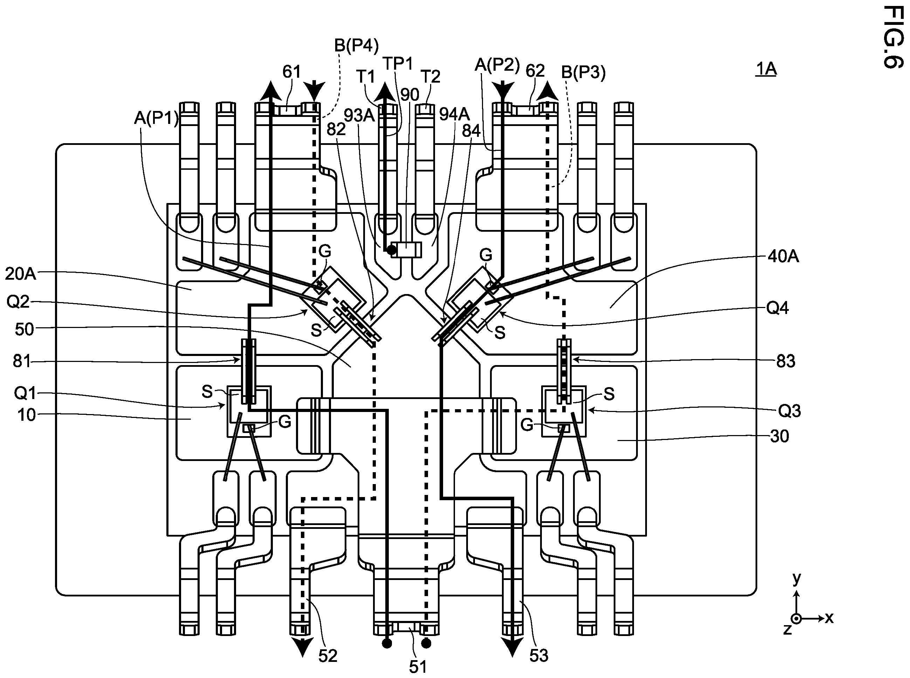

As illustrated in Fig. 5 and Fig. 6, the semiconductor module 1A basically has substantially the same configuration as the semiconductor module 1 according to the embodiment. However, the semiconductor module 1A includes neither the first capacitor nor the second capacitor. A temperature detection element 90, a first temperature detection terminal T1 and a second temperature detection terminal T2 in the semiconductor module 1A are equal to the corresponding constitutional elements in the semiconductor module 1. However, these constitutional elements differ in positions where these constitutional elements are disposed from the corresponding constitutional elements in the semiconductor module 1. Further, attributed to the presence or non-presence of the above-mentioned constitutional elements and or the above-mentioned difference in position, the semiconductor module 1A includes a second wiring pattern 20A, a fourth wiring pattern 40A, a first temperature detection pattern 93A and a second temperature detection pattern 94A having shapes that differ from the corresponding constitutional elements having the same names in the semiconductor module 1.

In the simulation, noises (fluctuation of voltage) that were generated in the first temperature detection path TP1 at the time of switching were measured in a state where frequency of an ON/OFF operation of the full bridge circuit 100 in the semiconductor module 1 and the semiconductor module 1A were set to 20 kHz.

As a result, as illustrated in Fig. 7, in the semiconductor module 1 according to the embodiment, noises that were generated in the first temperature detection path TP1 were largely reduced compared with the semiconductor module 1A according to the comparison example. Accordingly, in the semiconductor module 1 of the embodiment, an output voltage of the temperature detection element 90 becomes stable.

### 4. Advantageous effects of semiconductor module 1 according to embodiment

In the semiconductor module 1 according to the embodiment, the temperature detection element 90 is disposed in a region surrounded by the first switching path A and the second switching path B in the full bridge circuit 100, that is, in the region in the vicinity of the semiconductor elements (the second semiconductor element Q2 and the fourth semiconductor element Q4) that are heat generation sources. With such a configuration, the semiconductor module 1 according to the embodiment becomes a semiconductor module that can accurately perform the temperature detection compared to the prior art.

The semiconductor module 1 according to the embodiment includes: "a first capacitor 95 that is disposed between the first temperature detection path TP1 that extends from the first temperature detection electrode 91 to the first temperature detection terminal T1 and a common portion between a first current path P1 and a fourth current path P4"; "a second capacitor 96 that is disposed between the first temperature detection path TP1 and a common portion between a second current path P2 and a third current path P3". With such a configuration, according to the semiconductor module 1 of the embodiment, a capacitance between the first temperature detection path TP1 and the first current path P1 on the first switching path A and a capacitance between the first temperature detection path TP1 and the second current path P2 on the first switching path A are balanced and hence, noises generated at the time of switching can be reduced. Further, in the semiconductor module 1 according to the embodiment, a capacitance between the first temperature detection path TP1 and a third current path P3 on the second switching path B and a capacitance between the first temperature detection path TP1 and a fourth current path P4 on the second switching path B are balanced and hence noises generated at the time of switching can be reduced. As a result, an output voltage of the temperature detection element 90 becomes stable and hence, the semiconductor module 1 according to the embodiment becomes a semiconductor module that can perform the temperature detection in a more stable manner.

In the semiconductor module 1 according to the embodiment, the first capacitor 95 and the second capacitor 96 are disposed in the sealing material M. According to the semiconductor module 1 of the embodiment, by accommodating the constitutional elements including the first capacitor 95 and the second capacitor 96 in a package formed of the sealing material M, it is possible to provide a semiconductor module that can be handled with ease at the time of mounting the semiconductor module.

With respect to the semiconductor module 1 according to the embodiment, out of between the first temperature detection wiring pattern 93 and the wiring pattern (the second wiring pattern 20) that constitutes the common portion between the first current path P1 and the fourth current path P4, and between the first temperature detection wiring pattern 93 and the wiring pattern (the fourth wiring pattern 40) that constitutes the common portion between the second current path P2 and the third current path P3, the semiconductor module 1 includes the capacitive coupling reducing wiring pattern 97 on the side where the second temperature detection wiring pattern 94 is not disposed. With such a configuration, according to the semiconductor module 1 of the embodiment, due to the presence of the capacitive coupling reducing wiring pattern 97, a parasitic capacitance generated around the first temperature detection wiring pattern 93 can be reduced.

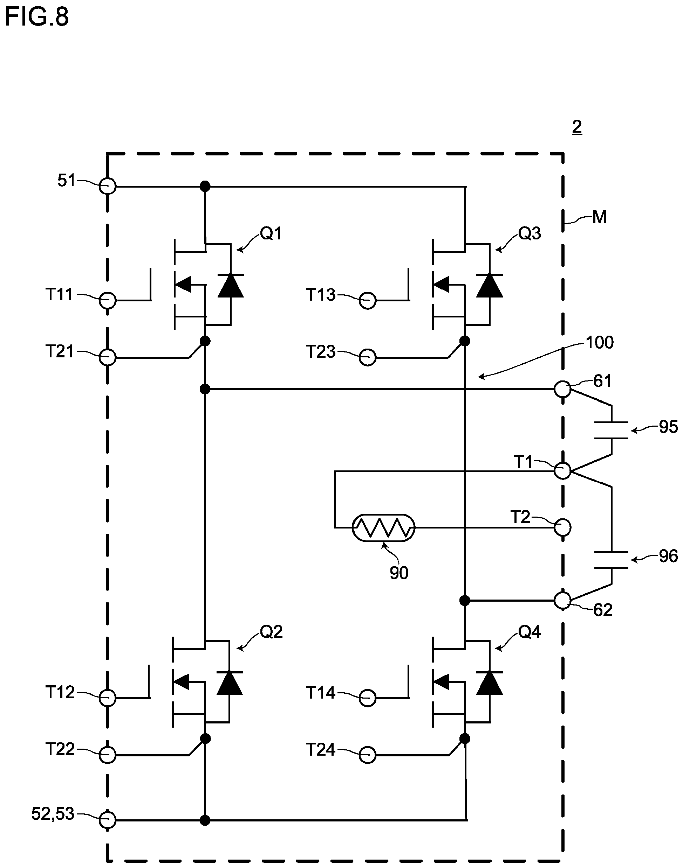

The present invention has been described based on the above-mentioned embodiment hereto for, the present invention is not limited to the above-mentioned embodiment. The present invention can be carried out in various modes without departing from the scope of the appended claims. For example, the following modifications are also conceivable.
(1) The positions, the sizes, the shapes and the like of the respective constitutional elements that are described in the above-mentioned embodiment and are illustrated in the respective drawings are provided for an exemplifying purpose, and can be changed within a scope where advantageous effects of the present invention are not impaired.
(2) In the above-mentioned embodiment, the first capacitor 95 and the second capacitor 96 are disposed in the sealing material M. However, the present invention is not limited to such a configuration. In the semiconductor module of the present invention, as in the case of a semiconductor module 2 according to the modification illustrated in Fig. 8, a first capacitor and a second capacitor may be disposed outside a sealing material. In the semiconductor module 2, a first capacitor 95 is connected between a first temperature detection terminal T1 and a first intermediate point terminal 61, and a second capacitor 96 is connected between the temperature detection terminal T1 and a second intermediate point terminal 62. With such a configuration, the degree of freedom in the arrangement of the first capacitor and the second capacitor is increased.
(3) In the above-mentioned embodiment, the second temperature detection wiring pattern 94 is disposed between the first temperature detection wiring pattern 93 and the fourth wiring pattern 40, and the capacitive coupling reducing wiring pattern 97 is disposed between the first temperature detection wiring pattern 93 and the second wiring pattern 20. However, the present invention is not limited to such a configuration. The arrangement of the second temperature detection wiring pattern and the capacitive coupling reducing wiring pattern may be reversed. In this case, it is necessary to also adjust the arrangement of the temperature detection element and the second temperature detection terminal.
(4) In the above-mentioned embodiment, the capacitive coupling reducing wiring pattern 97 is connected with neither the terminals nor different wiring patterns. However, the present invention is not limited to such a configuration. The capacitive coupling reducing wiring pattern may be connected with the terminals, the different wiring patterns and the like. It is desired that the terminals, the different wiring patterns and the like with which the capacitive coupling reducing wiring pattern is connected are terminals, wiring patterns and the like that are connected with connection destinations where voltages are stable when the semiconductor module is used. As the connection destination where the voltage is stable, for example, a ground and various power supplies can be exemplified. With such a configuration, a parasitic capacitance generated around the first temperature detection wiring pattern can be further reduce.

### [Reference Signs List]

1,2: semiconductor module
10: first wiring pattern
20: second wiring pattern
30: third wiring pattern
40: fourth wiring pattern
50: fifth wiring pattern
51: first power source terminal
52, 53: second power source terminal
61: first intermediate point terminal
62: second intermediate point terminal
90: temperature detection element
91: first temperature detection electrode
92: second temperature detection electrode
93: first temperature detection wiring pattern
94: second temperature detection wiring pattern
95: first capacitor
96: second capacitor
97: capacitive coupling reducing wiring pattern
100: full bridge circuit
A: first switching path
B: second switching path
M: sealing material
P1: first current path
P2: second current path
P3: third current path
P4: fourth current path
Q1: first semiconductor element
Q2: second semiconductor element
Q3: third semiconductor element
Q4: fourth semiconductor element
T1: first temperature detection terminal
T2: second temperature detection terminal
TP1: first temperature detection path

## Claims

1. A semiconductor module (1, 2) comprising: first to fourth semiconductor elements (Q1-Q4); a plurality of wiring patterns (10-50); a first power source terminal (51); a second power source terminal (52, 53); a first intermediate point terminal (61); and a second intermediate point terminal (62), wherein a full bridge circuit (100) is formed where a first switching path (A) and a second switching path (B) are formed exclusively by a switching operation, the first switching path including a first current path (P1) that extends from the first power source terminal (51) to the first intermediate point terminal (61) and a second current path (P2) that extends from the second intermediate point terminal (62) to the second power source terminal (52, 53), the second switching circuit including a third current path (P3) that extends from the first power source terminal (51) to the second intermediate point terminal (62) and a fourth current path (P4) that extends from the first intermediate point terminal (61) to the second power source terminal (52, 53), wherein
the semiconductor module further comprises:
a temperature detection element (90) that includes a first temperature detection electrode (91) and a second temperature detection electrode (92), and is disposed in a region surrounded by the first switching path (A) and the second switching path (B);
a first temperature detection wiring pattern (93) that is connected with the first temperature detection electrode (91);
a first temperature detection terminal (T1) that is a terminal to be connected with a temperature detection circuit, and is connected with the first temperature detection wiring pattern (93);
a second temperature detection wiring pattern (94) that is connected with the second temperature detection electrode (92);
a second temperature detection terminal (T2) that is a terminal to be connected with a ground or a control system power source, and is connected with the second temperature detection wiring pattern (94);
a first capacitor (95) that is disposed between a first temperature detection path (TP1) that extends from the first temperature detection electrode (91) to the first temperature detection terminal (T1) and a common portion between the first current path (P1) and the fourth current path (P4); and
a second capacitor (96) that is disposed between the first temperature detection path (TP1) and a common portion between the second current path (P2) and the third current path (P3).

2. The semiconductor module according to claim 1, wherein the semiconductor module further comprises:
a sealing material (M) that seals the first to fourth semiconductor elements (Q1-Q4) the plurality of wiring patterns (10-50) and the temperature detection elements (90), and seals respective inner lead portions of the first power source terminal (51), the second power source terminal (52, 53), the first intermediate point terminal (61), the second intermediate point terminal (62), the first temperature detection terminal (T1) and the second temperature detection terminal (T2), and
the first capacitor (95) and the second capacitor (96) are disposed in the sealing material (M).

3. The semiconductor module according to claim 1, wherein the semiconductor module further comprises:
a sealing material **(**M) that seals the first to fourth semiconductor elements (Q1-Q4) and the plurality of wiring patterns (10-50), and seals respective inner lead portions of the first power source terminal (51), the second power source terminal (52, 53), the first intermediate point terminal (61), and the second intermediate point terminal (62), and
the first capacitor (95) and the second capacitor (96) are disposed outside the sealing material (M).

4. The semiconductor module according to any one of claims 1 to 3, wherein the second temperature detection wiring pattern (94) is disposed between the first temperature detection wiring pattern (93) and a wiring pattern that constitutes a common portion between the first current path (P1) and the fourth current path (P4) or between the first temperature detection wiring pattern (93) and a wiring pattern that constitutes a common portion between the second current path (P2) and the third current path (P3), and
the semiconductor module further comprises a capacitive coupling reducing wiring pattern (97) that is disposed on a side where the second temperature detection wiring pattern (94) is not disposed, out of between the first temperature detection wiring pattern (93) and a wiring pattern that constitutes a common portion between the first current path (P1) and the fourth current path (P4) and between the first temperature detection wiring pattern (93) and a wiring pattern that constitutes a common portion between the second current path (P2) and the third current path (P3).

## Patentansprüche

1. Halbleitermodul (1, 2) aufweisend: vier Halbleiterelemente (Q1 - Q4); eine Mehrzahl von Verdrahtungsstrukturen (10 - 50); einen ersten Stromversorgungsanschluss (51); einen zweiten Stromversorgungsanschluss (52, 53); einen ersten Verteileranschluss (61); und einen zweiten Verteileranschluss (62), wobei eine Vollbrückenschaltung (100) gebildet ist, in welcher ein erster Schaltweg (A) und ein zweiter Schaltweg (B) ausschließlich durch einen Schaltvorgang gebildet werden, der erste Schaltweg einen ersten Strompfad (P1), welcher sich vom ersten Stromversorgungsanschluss (51) zum ersten Verteileranschluss (61) erstreckt, und einen zweiten Strompfad (P2), welcher sich vom zweiten Verteileranschluss (62) zum zweiten Stromversorgungsanschluss (52, 53) erstreckt, aufweist, die zweite Schaltanordnung einen dritten Strompfad (P3), welcher sich vom ersten Stromversorgungsanschluss (51) zum zweiten Verteileranschluss (62) erstreckt, und einen vierten Strompfad (P4), welcher sich vom ersten Verteileranschluss (61) zum zweiten Stromversorgungsanschluss (52, 53) erstreckt, aufweist, wobei das Halbleitermodul ferner aufweist:
ein Temperaturerfassungselement (90), welches eine erste Temperaturerfassungselektrode (91) und eine zweite Temperaturerfassungselektrode (92) aufweist und in einem Bereich, welcher vom ersten Schaltweg (A) und vom zweiten Schaltweg (B) umgeben ist, angeordnet ist;
eine erste Temperaturerfassungsverdrahtungsstruktur (93), welche mit der ersten Temperaturerfassungselektrode (91) verbunden ist;
einen ersten Temperaturerfassungsanschluss (T1), bei welchem es sich um einen mit der Temperaturerfassungsschaltung zu verbindenden Anschluss handelt, welcher mit der ersten Temperaturerfassungsverdrahtungsstruktur (93) verbunden ist;
eine zweite Temperaturerfassungsverdrahtungsstruktur (94), welche mit der zweiten Temperaturerfassungselektrode (92) verbunden ist;
einen zweiten Temperaturerfassungsanschluss (T2), bei welchem es sich um einen mit einer Masse oder einer Steuersystemstromquelle zu verbindenden Anschluss handelt, welcher mit der zweiten Temperaturerfassungsverdrahtungsstruktur (94) verbunden ist;
einen ersten Kondensator (95), welcher zwischen einem ersten Temperaturerfassungspfad (TP1), welcher sich von der ersten Temperaturerfassungselektrode (91) zum ersten Temperaturerfassungsanschluss (T1) erstreckt, und einem gemeinsamen Abschnitt zwischen dem ersten Strompfad (P1) und dem vierten Strompfad (P4) angeordnet ist; und
einen zweiten Kondensator (96), welcher zwischen dem ersten Temperaturerfassungspfad (TP1) und einem gemeinsamen Abschnitt zwischen dem zweiten Strompfad (P2) und dem dritten Strompfad (P3) angeordnet ist.

2. Halbleitermodul nach Anspruch 1, wobei das Halbleitermodul ferner aufweist:
ein Dichtungsmaterial (M), welches die vier Halbleiterelemente (Q1 - Q4), die Mehrzahl von Verdrahtungsstrukturen (10 - 50) und die Temperaturerfassungselemente (90) abdichtet, und welches jeweils innere Leitungsabschnitte des ersten Stromversorgungsanschlusses (51), des zweiten Stromversorgungsanschlusses (52, 53), des ersten Verteileranschlusses (61), des zweiten Verteileranschlusses (62), des ersten Temperaturerfassungsanschlusses (T1) und des zweiten Temperaturerfassungsanschlusses (T2) abdichtet, und
wobei der erste Kondensator (95) und der zweite Kondensator (96) im Dichtungsmaterial (M) angeordnet sind.

3. Halbleitermodul nach Anspruch 1, wobei das Halbleitermodul ferner aufweist:
ein Dichtungsmaterial (M), welches die vier Halbleiterelemente (Q1 - Q4) und die Mehrzahl von Verdrahtungsstrukturen (10 - 50) abdichtet, und welches jeweils innere Leitungsabschnitte des ersten Stromversorgungsanschlusses (51), des zweiten Stromversorgungsanschlusses (52, 53), des ersten Verteileranschlusses (61) und des zweiten Verteileranschlusses (62) abdichtet, und
wobei der erste Kondensator (95) und der zweite Kondensator (96) außerhalb des Dichtungsmaterials (M) angeordnet sind.

4. Halbleitermodul nach einem der Ansprüche 1 bis 3, wobei die zweite Temperaturerfassungsverdrahtungsstruktur (94) zwischen der ersten Temperaturerfassungsverdrahtungsstruktur (93) und einer Verdrahtungsstruktur, welche einen gemeinsamen Abschnitt zwischen dem ersten Strompfad (P1) und dem vierten Strompfad (P4) darstellt, oder zwischen der ersten Temperaturerfassungsverdrahtungsstruktur (93) und einer Verdrahtungsstruktur, welche einen gemeinsamen Abschnitt zwischen dem zweiten Strompfad (P2) und dem dritten Strompfad (P3) darstellt, angeordnet ist, und
das Halbleitermodul ferner eine Verdrahtungsstruktur zum Reduzieren einer kapazitiven Kopplung (97) aufweist, welche an einer Seite, an welcher die zweite Temperaturerfassungsverdrahtungsstruktur (94) nicht angeordnet ist, zwischen der ersten Temperaturerfassungsverdrahtungsstruktur (93) und einer Verdrahtungsstruktur, welche einen gemeinsamen Abschnitt zwischen dem ersten Strompfad (P1) und dem vierten Strompfad (P4) darstellt, und zwischen der ersten Temperaturerfassungsverdrahtungsstruktur (93) und einer Verdrahtungsstruktur, welche einen gemeinsamen Abschnitt zwischen dem zweiten Strompfad (P2) und dem dritten Strompfad (P3) darstellt, angeordnet ist.

## Revendications

1. Module à semi-conducteurs (1, 2) comprenant : des premier à quatrième éléments semi-conducteurs (Q1-Q4) ; une pluralité de motifs de câblage (10-50) ; une première borne de source d'alimentation (51) ; une deuxième borne de source d'alimentation (52, 53) ; une première borne de point intermédiaire (61) ; et une deuxième borne de point intermédiaire (62), où un circuit en pont complet (100) est formé là où un premier chemin de commutation (A) et un deuxième chemin de commutation sont formés exclusivement par une opération de commutation, le premier chemin de commutation comportant un premier chemin de courant (P1) qui s'étend de la première borne de source d'alimentation (51) vers la première borne de point intermédiaire (61) et un deuxième chemin de courant (P2) qui s'étend de la deuxième borne de point intermédiaire (62) vers la deuxième borne de source d'alimentation (52, 53), le deuxième circuit de commutation comprenant un troisième chemin de courant (P3) qui s'étend de la première borne de source d'alimentation (51) à la deuxième borne de point intermédiaire (62) et un quatrième chemin de courant (P4) qui s'étend de la première borne de point intermédiaire (61) à la deuxième borne de source d'alimentation (52, 53), où le module à semi-conducteurs comprend en outre :
un élément de détection de température (90) qui comprend une première électrode de détection de température (91) et une deuxième électrode de détection de température (92), et qui est disposé dans une région entourée par le premier chemin de commutation (A) et le deuxième chemin de commutation (B) ;
un premier motif de câblage de détection de température (93) qui est connecté à la première électrode de détection de température (91) ;
une première borne de détection de température (T1) qui est une borne à connecter à un circuit de détection de température et qui est connectée au premier motif de câblage de détection de température (93) ;
un deuxième motif de câblage de détection de température (94) qui est connecté à la deuxième électrode de détection de température (92) ;
une deuxième borne de détection de température (T2) qui est une borne à connecter à une masse ou à une source d'alimentation du système de commande, et qui est connectée au deuxième motif de câblage de détection de température (94) ;
un premier condensateur (95) qui est disposé entre un premier chemin de détection de température (TP1) qui s'étend de la première électrode de détection de température (91) à la première borne de détection de température (T1) et une partie commune entre le premier chemin de courant (P1) et le quatrième chemin de courant (P4) ; et
un deuxième condensateur (96) qui est disposé entre le premier chemin de détection de température (TP1) et une partie commune entre le deuxième chemin de courant (P2) et le troisième chemin de courant (P3).

2. Module à semi-conducteurs selon la revendication 1, dans lequel le module à semi-conducteurs comprend en outre :
un matériau d'étanchéité (M) qui scelle les premier à quatrième éléments semi-conducteurs (Q1-Q4), la pluralité de motifs de câblage (10-50) et les éléments de détection de température (90), et scelle les parties conductrices internes respectives de la première borne de source d'alimentation (51), de la deuxième borne de source d'alimentation (52, 53), de la première borne de point intermédiaire (61), de la deuxième borne de point intermédiaire (62), de la première borne de détection de température (T1) et de la deuxième borne de détection de température (T2), et
le premier condensateur (95) et le deuxième condensateur (96) étant disposés dans le matériau d'étanchéité (M).

3. Module à semi-conducteurs selon la revendication 1, dans lequel le module à semi-conducteurs comprend en outre :
un matériau d'étanchéité (M) qui scelle les premier à quatrième éléments semi-conducteurs (Q1-Q4) et la pluralité de motifs de câblage (10-50), et scelle les parties conductrices internes respectives de la première borne de source d'alimentation (51), de la deuxième borne de source d'alimentation (52, 53), de la première borne de point intermédiaire (61) et de la deuxième borne de point intermédiaire (62), et
le premier condensateur (95) et le deuxième condensateur (96) étant disposés à l'extérieur du matériau d'étanchéité (M).

4. Module à semi-conducteurs selon l'une quelconque des revendications 1 à 3, dans lequel le deuxième motif de câblage de détection de température (94) est disposé entre le premier motif de câblage de détection de température (93) et un motif de câblage qui constitue une partie commune entre le premier chemin de courant (P1) et le quatrième chemin de courant (P4) ou entre le premier motif de câblage de détection de température (93) et un motif de câblage qui constitue une partie commune entre le deuxième chemin de courant (P2) et le troisième chemin de courant (P3), et
le module à semi-conducteurs comprend en outre un motif de câblage de réduction de couplage capacitif (97) qui est disposé d'un côté où le deuxième motif de câblage de détection de température (94) n'est pas disposé, entre le premier motif de câblage de détection de température (93) et un motif de câblage qui constitue une partie commune entre le premier chemin de courant (P1) et le quatrième chemin de courant (P4) et entre le premier motif de câblage de détection de température (93) et un motif de câblage qui constitue une partie commune entre le deuxième chemin de courant (P2) et le troisième chemin de courant (P3).
